# EUROPÄISCHE PATENTSCHRIFT

(11) **EP 3 894 258 B1**
(45) Veröffentlichungstag und Bekanntmachung des Hinweises auf die Patenterteilung: **11.01.2023**
(21) Anmeldenummer: 19813766.3
(22) Anmeldetag: 29.11.2019
(51) Int. Cl.: H03K 17/96, B60K 37/06

(54) **DACHKONSOLE FÜR EIN FAHRZEUG**
ROOF CONSOLE FOR A VEHICLE
CONSOLE DE TOIT POUR UN VÉHICULE

(30) Priorität: 13.12.2018 DE 102018221710
(43) Veröffentlichungstag der Anmeldung: 20.10.2021
(73) Patentinhaber: VOLKSWAGEN AKTIENGESELLSCHAFT, 38440 Wolfsburg (DE)
(72) Erfinder: SEIDL, Nicolas, 38106 Braunschweig (DE); ROSILIUS, Marcel, 38440 Wolfsburg (DE)
(86) Internationale Anmeldenummer: PCT/EP2019/083033
(87) Internationale Veröffentlichungsnummer: WO 2020/120167

(56) Entgegenhaltungen:
- WO-A1-2019/114981
- DE-A1-102014 008 432
- US-A1- 2017 253 121

## Beschreibung

Die Erfindung betrifft eine Dachkonsole für ein Fahrzeug.

In vielen Fahrzeugen, insbesondere Personenkraftwagen, sind Dachkonsolen vorhanden, in denen häufig die Bedienelemente für ein Schiebe- und/oder Ausstelldach, gegebenenfalls für einen Sonnenschutz für das Schiebe- oder Ausstelldach, für die Innenraumbeleuchtung und eventuell noch andere Fahrzeugfunktionen integriert sind. Die Dachkonsolen sind gemeinhin vorn, zwischen Schiebe-/Ausstelldach und Frontscheibe und bezogen auf die Fahrzeugbreite mittig angeordnet. Die Bedienelemente für das Schiebe- und/oder Ausstelldach sind zumeist in der Dachkonsole angeordnete mechanische Mehrwegeschalter, mit denen die verschiedenen Dachfunktionen schaltbar sind.

Nachteilig an diesen Dachkonsolen sind die kostenintensiven und reparaturanfälligen mechanische Mehrwegeschalter. Zudem ist es über den Mehrwegschalter schwierig automatische und manuelle Öffnungs- beziehungsweise Schließvorgänge aller Öffnungsfunktionen (wie Schiebe- und Ausstellfunktionen) abzudecken. Zudem sind Dachkonsolen nach dem Stand der Technik nur unzureichend für eine Blindbedienung geeignet, dadurch gekennzeichnet, dass die Mehrwegschalter blind nur schlecht auffindbar sind.

US 2017/0253121 A1 offenbart eine Dachkonsole für ein Fahrzeug, das ein Touch-Slide-Bedienelement aufweist. Die Oberfläche des Touch-Slide-Bedienelements ist auf der Oberfläche der Dachkonsole ausgebildet.

Der Erfindung liegt nun die Aufgabe zugrunde, eine Dachkonsole vorzuschlagen, die kostengünstig herzustellen und einfach zu montieren ist, sowie eine einfache, möglichst blinde, Bedienung der Dachfunktionen ermöglicht.

Erfindungsgemäß wird diese Aufgabe gelöst durch eine Dachkonsole mit den Merkmalen des Anspruches 1. Vorteilhafte Weiterbildungen der Erfindung sind Gegenstand von Unteransprüchen.

Die erfindungsgemäße Dachkonsole für ein Fahrzeug weist mindestens ein Touch-Slide-Bedienelement zur Bedienung von Fahrzeugfunktionen auf. Erfindungsgemäß ist die Oberfläche mindestens eines Touch-Slide-Bedienelements gegenüber der Oberfläche der Umgebung des Touch-Slide-Bedienelementes vertieft oder erhöht. Mit anderen Worten liegt die berührungssensitive Oberfläche des Touch-Slide- Bedienelementes in einer Vertiefung, auch als Mulde bezeichnet, oder auf einer Erhöhung, auch als Rippe bezeichnet. Die Grundfläche von Vertiefung oder Erhöhung ist dabei bevorzugt rechteckeckig, entsprechend dem berührungssensitiven Eingabebereich des Touch-Slide-Bedienelements. Vorteilhaft sind die Touch-Slide-Bedienelemente so besonders gut für Blindbedienung geeignet, da die Hand lediglich die Vertiefung oder Erhöhung auffinden muss, und die Bedienung dann problemlos blind erfolgen kann. Zudem können weiterhin vorteilhaft Fehlbedienung weitestgehend ausgeschlossen werden, da durch die erfindungsgemäße Vertiefung oder Erhöhung zufällige ungewollte Berührungen verhindert werden.

Ein Touch-Slide-Bedienelement im Sinne dieser Erfindung ist ein berührungssensitives Bedienelemente mit einer eindimensionalen Ausdehnung. Vorteilhaft können Touch-Slide-Bedienelemente durch die eindimensionale Ausdehnung Gesten in Form von Tippen und Wischen erkennen, wodurch eine Vielzahl von Gesten und Befehlen implementierbar sind. Die Wischbewegungen sind zudem in beide Richtungen der eindimensionalen Ausdehnung detektierbar. Bevorzugt sind die Sensoren der Touch-Bedienelemente dabei kapazitive Sensoren, da diese kostengünstig erhältlich sind und ein gutes Ansprechverhalten aufweisen. Es sind jedoch auch andere Systeme, beispielsweise optische oder resistive Sensoren einsetzbar.

Die Vertiefung des Touch-Slide-Bedienelements wird mit zunehmender Tiefe schmaler (die Breite der Vertiefung nimmt ab). Gleichfalls verjüngt sich die Erhöhung auf der sich das Touch-Slide-Bedienelement befindet mit zunehmender Höhe (Breite nimmt mit zunehmender Höhe ab). Mit anderen Worten hat ein Schnitt quer durch die Erhöhung beziehungsweise Vertiefung eine Trapezform, wobei das Touch-Slide-Bedienelement auf der kürzeren der beiden parallelen Seiten angeordnet ist. Vorteilhaft kann so das Auffinden des berührungssensitiven Eingabebereichs des Touch-Slide-Bedienelements erleichtert werden.

Bevorzugt hat Erhöhung oder Vertiefung im Bereich des Touch-Slide-Bedienelementes eine Breite von 50% bis 90% der Ausgangsbreite, besonders bevorzugt eine Breite von 60% bis 80% der Ausgangsbreite (Ausgangsbreite bezeichnet die Breite der Erhöhung/Vertiefung auf dem Höhenniveau der Umgebungsfläche). Dabei kann eine Erhöhung durchaus mit einer schmaleren Breite des Touch-Slide-Bedienelements ausgeführt werden, bei einer Vertiefung ist im demgegenüber darauf zu achten, dass ein Finger für eine Bedienung in die Vertiefung passen muss.

In einer besonders bevorzugten Ausgestaltung sind zwei Touch-Slide-Bedienelemente, die bevorzugt die gleiche Länge aufweisen, unmittelbar nebeneinander in jeweils einer Vertiefung beziehungsweise auf jeweils einer Erhöhung angeordnet und durch eine Abgrenzung getrennt. Die Abgrenzung ist dabei zwischen zwei in einer Vertiefung angeordneten Touch-Slide-Bedienelementen bevorzugt als Steg ausgebildet und bei auf einer Erhöhung befindlichen Touch-Slide-Bedienelementen bevorzugt als Spalt. Eine derartige Anordnung ist besonders gut geeignet für verbundene Fahrzeugfunktionen. In einer bevorzugten Ausführung hat die Abgrenzung eine Tiefe/Höhe von 20% bis 80% der Gesamthöhe/Gesamttiefe, weiter bevorzugt zwischen 30% und 70% und besonders bevorzugt zwischen 40% und 60% der Gesamthöhe/Gesamttiefe (zur Klarstellung: Höhe des Steges als Abgrenzung bei einer Vertiefung und Tiefe des Spaltes als Abgrenzung bei einer Erhöhung bezogen auf die Gesamthöhe/Gesamttiefe).

Weiterhin bevorzugt sind alle Kanten der Vertiefungen beziehungsweise Erhöhungen abgerundet ausgeführt. Vorteilhaft kann so der haptische Eindruck angenehmer gestaltet werden.

In einer besonders bevorzugten Ausgestaltung sind beispielsweise ein Touch-Slide-Bedienelement zur Steuerung eines Schiebedaches und ein Touch- Slide-Bedienelement zur Steuerung des Sonnenschutzes des Schiebedaches nebeneinander angeordnet. Vorteilhaft kann der Benutzer so beide Fahrzeugfunktionen, im Beispiel eine Öffnung von Schiebedach und des Sonnenschutzes durch eine mit zwei Fingern derselben Hand ausgeführte Geste bedienen.

In einer alternativen Ausgestaltung können mittels eines Touch-Slide-Bedienelementes auch mehrere Fahrzeugfunktionen bedient werden. Beispielsweise kann ein Touch-Slide-Bedienelement so konfiguriert sein, dass durch eine Wischbewegung ein Schiebedach und gleichzeitig der Sonnenschutz geöffnet werden. Vorteilhaft kann so die Bedienung weiter vereinfacht werden.

In einer weiteren besonders bevorzugten Ausgestaltung hat die Abgrenzung ein Höhenniveau, dass zwischen dem der Erhöhung oder der Vertiefung und dem der umgebenden Oberfläche liegt. Diese Ausgestaltung ist haptische sehr vorteilhaft, da die Abgrenzung einfach aufzufinden ist und einen guten Bezugspunkt darstellt, von dem ausgehend eine Blindbedienung der beiden benachbarten Touch-Slide-Bedienelemente sehr gut möglich ist.

In einer weiterhin bevorzugten Ausführung hat die Erhöhung oder Vertiefung im Bereich des Touch-Slide-Bedienelements eine Breite zwischen 1 cm und 4 cm, besonders bevorzugt zwischen 1,8 cm und 3 cm. Vorteilhaft passt bei einer Breite in diesem Bereich ein durchschnittlicher Finger in die Vertiefung beziehungsweise auf den Touch-Slide-Bereich der Erhöhung. Bei Wischbewegungen in der Vertiefung wird der Finger bei dieser Breite auf dem berührungsempfindlichen Bereich des Touch-Slide-Bedienelements geführt. Dies erleichtert eine Blindbedienung.

Weiterhin bevorzugt hat die Vertiefung/Erhöhung eine Tiefe/Höhe von 30% bis 140% der Breite im Bereich des Touch-Slide-Bedienelements, weiter bevorzugt zwischen 50% und 120% und besonders bevorzugt zwischen 60% und 100%. Vorteilhaft ist das haptische Empfinden bei einem Verhältnis von Tiefe (Höhe) und Breite in diesem Bereich besonders komfortabel und eine Blindbedienung wird begünstigt.

Weiterhin bevorzugt hat die Erhöhung beziehungsweise Vertiefung des Touch-Slide-Bedienelements auf dem Höhenniveau des Touch-Slide-Bedienelements eine Länge von 3 cm bis 10 cm, weiter bevorzugt zwischen 3,5 cm und 7 cm und besonders bevorzugt zwischen 4 cm und 6 cm. Auch bezüglich der Länge verkürzt sich die Vertiefung/Erhöhung mit zunehmender Höhe/Tiefe. Die Länge der Vertiefung/Erhöhung auf dem Höhenniveau der Umgebungsfläche ist bevorzugt 110% bis 200% der Ausgangsbreite, weiter bevorzugt im Bereich zwischen 130% und 180% und besonders bevorzugt zwischen von 140% bis 160%. Bevorzugt sind die Touch-Slide-Bedienelemente in Fahrtrichtung ausgerichtet in der Dachkonsole positioniert. Dies bedeutet, dass die eindimensionale Ausdehnung des berührungssensitiven Eingabebereichs der Touch-Slide-Bedienelemente eine Ausrichtung von der Frontscheibe zur Heckscheibe aufweisen. Vorteilhaft passt eine derartige Anordnung sehr gut zur Bedienlogik eines Schiebedaches oder Sonnenschutzes.

Das mindestens eine Touch-Slide-Bedienelement der erfindungsgemäße Dachkonsole ist zur Bedienung beispielsweise von folgenden Fahrzeugfunktionen vorgesehen: ein Schiebe-und/oder Ausstelldach, ein Sonnenrollo oder anderer öffenbarer Sonnenschutz eines Schiebe-/Ausstelldaches, Funktionsglas, beispielsweise elektrochromes Glas, das eine Verdunklung ermöglicht und als Sonnenschutz Einsatz findet, ein Cabrio Verdeck, eine motorische Heckklappe, ein Fensterheber oder eine Innenraumbeleuchtung des Fahrzeuges. Um die Bedienung mehrerer Fahrzeugfunktionen über ein Touch-Slide-Bedienelement zu ermöglichen, können in der Umgebung des Touch-Slide-Bedienelements Taster (bevorzugt ebenfalls als Touch-Bedienelement ausgeführt) vorgesehen sein, mit denen der Benutzer das mit dem Touch-Slide-Bedienelement zu steuernde Fahrzeugfunktionen auswählt. Bevorzugt sind die Taster zur Auswahl in unmittelbarer Umgebung des Touch-Slide-Bedienelements, um eine einhändige Bedienung zu ermöglichen. Vorteilhaft kann so eine einfache und übersichtliche Bedienung für eine Vielzahl von Fahrzeugfunktionen realisiert werden.

Ein Schiebe-/Ausstelldach bezeichnet hier ein öffenbares Dach, dass zum einen durch eine Schiebefunktion einen zu öffnenden Dachbereiches über, in oder unter einen benachbarten Dachbereich bewegt. Viele Schiebedächer haben zudem eine Ausstellfunktion, bei der das Dach mit seinem in Fahrtrichtung gesehen hinteren Bereich nach oben angehoben wird, wodurch ein Luftaustausch ermöglicht wird, ohne das Regen in das Fahrzeug eindringen kann. Die Erfindung kann sowohl bei reinen Schiebedächern, reinen Ausstelldächern und Kombinationen eingesetzt werden.

Die erfindungsgemäße Dachkonsole hat bevorzugt ein Steuergerät, dass die eingegebenen Gesten erkennt und in Steuersignale für das Zielgerät (Schiebe-/Ausstelldach, Sonnenrollo, etc.) umwandelt.

Besonders bevorzugt ist die Dachkonsole derart konfiguriert, dass eine Wischbewegung über eine definierte Länge l1 eine automatisierte vollständige Öffnung oder Schließung des Daches oder des Sonnenrollos auslöst. Besonders bevorzugt bewirkt eine Wischbewegung in Öffnungsrichtung des Schiebedaches eine Öffnung des Daches und eine Wischbewegung in Schließrichtung des Daches dessen Schließung. Die definierte Länge l1 ist dabei so ausgewählt, dass ein wesentlicher Teil des Touch-Slide-Bedienelementes überstrichen wird, ohne dass der Nutzer sich darauf achten muss, die gesamte Länge zu überstreichen. Bevorzugt ist die Länge l1 zwischen 50% und 90% der Gesamtlänge des Touch-Slide-Bedienelementes, besonders bevorzugt zwischen 60% und 80%. Vorteilhaft kann der Benutzer so durch eine einfache, schnell und blind ausführbare Geste eine vollständige Öffnung beziehungsweise Schließung des Daches bewirken.

Weiterhin bevorzugt kann der Benutzer durch ein weiteres beliebiges Tippen auf das Touch-Slide-Bedienelement die automatisierte vollständige Öffnungs- oder Schließbewegung stoppen. Dabei ist bevorzugt die Empfindlichkeit des Touch-Slide-Bedienelementes so eingestellt, dass eine Fehlbedienung durch ein in die Nähe kommen, beispielsweise durch ein blindes Suchen eines anderen Bedienelementes der Dachkonsole, minimiert werden kann. Vorteilhaft kann der Nutzer so mittels einer kaum Aufmerksamkeit erfordernden Geste das Dach oder den Sonnenschutz auf die gewünschte Öffnungsweite einstellen.

In einer weiteren bevorzugten Ausgestaltung ist die Dachkonsole derart konfiguriert, dass eine Wischbewegung über eine definierte Länge l2 und das anschließende Verweilen des Fingers nach der Wischbewegung am Endpunkt der Wischbewegung eine Öffnungs- oder Schließbewegung auslöst, die bis zum Abheben des Fingers andauert. Die definierte Länge l2 ist analog zur Länge l1 so gewählt, dass die Bedienung einfach ist und kaum Aufmerksamkeit erfordert und blind gut zu bewerkstelligen ist, jedoch Fehlbedienungen minimiert werden. Bevorzugt ist die Länge l2 zwischen 50% und 90% der Gesamtlänge des Touch-Slide-Bedienelementes, besonders bevorzugt zwischen 60% und 80%. Vorteilhaft wird so eine weitere Möglichkeit der Bedienung von Dach oder Sonnenschutz geschaffen, wodurch die Bedienung intuitiver ist.

In einer weiteren bevorzugten Ausgestaltung ist das Touch-Slide-Bedienelement der Dachkonsole so konfiguriert, dass ein Tippen an beliebiger Stelle auf das Touch-Slide-Bedienelement eine Bewegung in die Ausstelllage oder ein Schließen des Daches aus der Ausstelllage bewirkt. Weiterhin bevorzugt kann der Öffnungs- oder auch der Schließvorgang durch ein erneutes Tippen gestoppt werden und so die Ausstellposition des Daches eingestellt werden. Auch hier wird vorteilhaft eine einfache, schnell und blind ausführbare Geste geschaffen, die die Ablenkung des Fahrers minimiert.

In einer weiteren bevorzugten Ausgestaltung der Dachkonsole ist das Touch-Slide-Bedienelement zur Steuerung eines Schiebedaches oder Sonnenschutzes derart konfiguriert, dass ein Tippen in die Randbereiche des Touch-Slide-Bedienelements eine Bewegung in die durch den Randbereich gegebene Richtung bewirkt. Bevorzugt findet die Bewegung des Daches oder Sonnenschutzes statt solange der Finger auf dem Touch-Slide-Bedienelement aufliegt.

In einer alternativen Ausgestaltung kann auch ein Automatiklauf durch ein kurzes Antippen im Randbereich gestartet werden. Dann ist jedoch die oben beschriebene Bedienung der Ausstellfunktion auf den mittleren Bereich des Touch-Slide-Bedienelementes beschränkt.

Die Randbereiche sind dabei so gewählt, dass keine übermäßige Präzision für den Benutzer zur Positionsfindung notwendig ist, jedoch auch eine klare Abgrenzung zum mittleren Bereich gegeben ist. Bevorzugt hat der der vordere oder hintere Randbereich jeweils eine Länge von 5% bis 20% der Gesamtlänge des Touch-Slide-Bedienelementes, besonders bevorzugt zwischen 10% und 15%. Vorteilhaft wird so eine weitere Bedienmöglichkeit geschaffen.

In einer besonders bevorzugten Ausgestaltung weist die Dachkonsole zwei direkt nebeneinander positionierte Touch-Slide-Bedienelemente auf, die zudem gleich groß sind. Durch die Positionierung direkt nebeneinander ist es vorteilhaft möglich beide Touch-Slide-Bedienelemente gleichzeitig mit zwei Fingern einer Hand zu bedienen. Besonders bevorzugt sind Touch-Slide-Bedienelemente für ein Schiebedach und einen Sonnenschutz für das Schiebedach nebeneinander positioniert, da so vorteilhaft Schiebedach und Sonnenschutz vorteilhaft gleichzeitig bedienbar sind.

In einer weiterhin bevorzugten Ausgestaltung ist die Mitte des Touch-Slide-Bedienelements haptisch wahrnehmbar für den Benutzer, beispielsweise durch eine besondere Strukturierung der Oberfläche. Besonders bevorzugt ist die gesamte Oberfläche des Touch-Slide-Bedienelementes haptisch abgesetzt von der Umgebungsfläche, beispielsweise über eine Riffelung in Querrichtung zur Ausdehnungsrichtung des Touch-Slide-Bedienelementes. In einer besonders bevorzugten Ausgestaltung nimmt der Abstand der Querriffelung zum Randbereich des Touch-Slide-Bedienelementes zu. Eine derartige Ausgestaltung vereinfacht vorteilhaft eine Blindbedienung deutlich, da nicht nur das Auffinden des Touch-Slide-Bedienelementes erleichtert wird, sondern auch die Positionsfindung darauf.

Weiterhin bevorzugt weist die Dachkonsole zudem eine dimmbare Beleuchtung auf. Bevorzugt eine mittig angeordnete Innenraumbeleuchtung, und/oder mittels seitlich und auf die vorderen Sitze gerichteter Beleuchtung, die besonders zum Lesen geeignet sind. Besonders bevorzugt erfolgt die Beleuchtung mittels LEDs, da diese vorteilhaft kostengünstig und energiesparend sind. In einer besonders bevorzugten Ausgestaltung ist die Beleuchtung dimmbar.

Die Bedienung der dimmbaren Beleuchtung wird bevorzugt realisiert indem die Lichtaustrittsfläche selbst als Touch-Bedienelement ausgeführt ist. In einer alternativen Ausgestaltung kann auch ein benachbarter Bereich als ein Touch-Bedienelement sein. Bevorzugt erfolgt die Bedienung mittels Tippen, also einem Auflegen und anschließendes Entfernen des Fingers vom Touch-Bedienelement zum Ein-/Ausschalten. Beim Antippen und Halten des Fingers auf dem Bedienelement, auch als Long-Press bezeichnet, wird nach kurzer Verzögerung die Lichtintensität langsam verringert bis der Benutzer den Finger vom Touch-Bedienelement nimmt. Alternativ kann das Tippen und halten auch ein Steigerung der Leuchtintensität ausgelöst werden kann, bis der Benutzer den Finger vom Touch-Bedienelement der Beleuchtung nimmt. Vorteilhaft ermöglicht die Zusammenlegung aller Beleuchtungsfunktionen in ein Bedienelement eine einfache intuitive Blindbedienung, insbesondere wenn die Lichtaustrittsfläche gleichzeitig Bedienelement ist, da ein optisches Erkennen von Bedienelementen neben den Lichtaustrittsflächen bei eingeschalteter Beleuchtung nur sehr schwer möglich ist.

In einer besonders bevorzugten Ausgestaltung ist eine Bedienung der Fondbeleuchtung des Fahrzeuges ebenfalls über Bedienelemente in der Dachkonsole möglich, bevorzugt ebenfalls dimmbar über ein Touch-Bedienelement wie oben beschrieben. Vorteilhaft kann so die gesamte Innenraumbeleuchtung des Fahrzeuges von den vorderen Sitzplätzen aus bedient werden.

Weitere bevorzugt als Touch-Bedienelement ausgeführte Bedienelemente können eine SOS-Taster, ein Info- oder Pannenruftaster, ein Taster für die Türkontaktvorwahl (also die Vorwahl, ob die sich die Beleuchtung beim Öffnen einer Tür automatisch einschalten soll), ein Taster für die Heck- oder Kofferraumklappenöffnung oder -schließung, ein Taster für das Öffnen und Schließen eines Cabrio Verdecks oder ein Taster für die gesamte Innenbeleuchtung sein. Besonders bevorzugt ist dabei der SOS-Taster unter einer Sicherheitsklappe angeordnet, um vorteilhaft ein ungewolltes Auslösen zu verhindern. Eine Funktionsrückmeldung kann über die Hintergrundbeleuchtung eines im Touch-Bedienelement angeordneten Symbols erfolgen, beispielsweise über einen Farbumschlag. Die Hintergrundbeleuchtung der Touch-Bedienelemente kann dabei vorteilhaft Bauraum sparend über einen Lichtleiter realisiert sein.

Alle Touch-Bedienelemente der Dachkonsole sind dabei bevorzugt haptisch wahrnehmbar für den Benutzer, so dass der Benutzer die berührungssensitiven Eingabebereiche blind auffinden und bedienen kann. Hierfür hat der berührungssensitiven Eingabebereiche eines Touch-Bedienelements eine gegenüber seiner Umgebung anders haptisch wahrnehmbare Oberfläche, beispielsweise ganz oder teilflächig aufgeraut, ganz oder teilflächig beschichtet, oder anderweitig strukturiert. Die Oberfläche des berührungssensitiven Eingabebereichs kann zudem gegenüber seiner Umgebung abgesetzt also erhöht oder vertieft sein, oder eine zumindest teilweise Umrahmung aufweisen. Vorteilhaft kann so eine Blindbedienung erleichtert werden, da der berührungssensitive Eingabebereich ohne Blickkontakt nur durch haptische Wahrnehmung auffindbar ist.

Weiterhin bevorzugt weist die Dachkonsole ein bevorzugt digitales Mikrofon auf, das beispielsweise für eine Freisprechfunktion des Fahrzeuges oder auch für eine Sprachsteuerung eingesetzt werden kann. Vorteilhaft können durch die Position des Mikrofons in der Dachkonsole Sprachsignale von der Fahrer- oder Beifahrerposition mit geringem Einfluss von Umgebungsgeräuschen aufgezeichnet werden.

In einer weiterhin bevorzugten Ausgestaltung können in der Dachkonsole weitere Anzeigen für Fahrzeugfunktionen vorgesehen sein. Diese sind bevorzugt als hintergrundbeleuchtete Symbole ausgeführt. Die Anzeige kann dann durch eine An/Aus der Hintergrundbeleuchtung oder auch mittels eines Farbumschlags realisiert sein. Beispiele für anzeigbare Fahrzeugfunktionen sind eine Passenger Airbag Off Anzeige oder auch eine Türkontaktanzeige, also die Information über noch geöffnete Fahrzeugtüren. Vorteilhaft sind die Anzeigen in der Dachkonsole für alle Fahrzeuginsassen gut sichtbar angeordnet.

Weiterhin bevorzugt weist die Dachkonsole eine Sensorik zur Überwachung des Fahrzeuginnenraumes auf, die beispielsweise für Alarmsysteme nutzbar ist. Vorteilhaft ist der Innenraum, insbesondere der hintere Bereich, aus der Position der Dachkonsole besonders gut überwachbar.

In einer weiteren bevorzugten Ausgestaltung erfolgt die elektrische Verbindung der Dachkonsole mit dem Fahrzeug lediglich über eine vielpolige Steckverbindung. Vorteilhaft kann so der Montageaufwand vermindert werden.

Weitere bevorzugte Ausgestaltungen der Erfindung ergeben sich aus den übrigen, in den Unteransprüchen genannten Merkmalen.

Die verschiedenen genannten Ausführungsformen der Erfindung sind sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: eine erfindungsgemäße Dachkonsole,
- Figur 2: eine nähere Darstellung eines Touch-Slide-Bedienelements,
- Figur 3: zwei Touch-Slide-Bedienelemente auf einer Erhöhung angeordnet, und
- Figur 4: mehrere Querschnittsformen der erfindungsgemäßen Vertiefung oder Erhöhung.

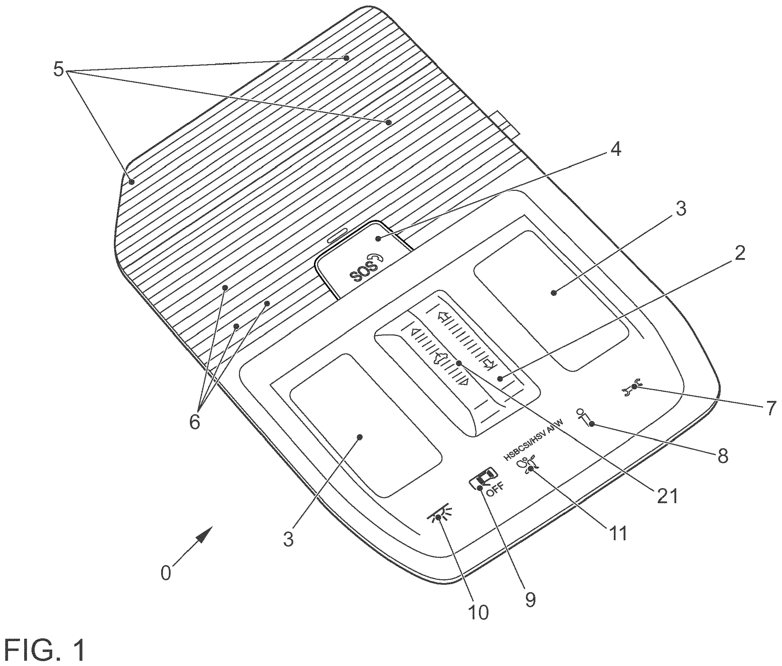

Figur 1 zeigt eine erfindungsgemäße Dachkonsole 0. Diese ist zum Einbau in ein Fahrzeugdach vorgesehen. Diese hat ein Touch-Slide-Bedienelement Dach 1 zur Öffnung des Panoramadaches des Fahrzeuges. Ein weiteres Touch-Slide-Bedienelement Sonnenschutz 2 ist zur Öffnung des im Panoramadach angeordneten Sonnenschutzes. Beide Touch-Slide-Bedienelemente 1, 2 sind in je einer Vertiefung angeordnet, die durch eine als Steg ausgebildete Abgrenzung 21 voneinander getrennt sind. Die Vertiefungen sind dabei gleich groß. Durch die Positionierung der beiden Touch-Slide-Bedienelemente Dach1 und Sonnenschutz 2 direkt nebeneinander kann der Nutzer beide Touch-Slide-Bedienelemente 1,2 durch den Einsatz von zwei Fingern, beispielsweise Zeige- und Mittelfinger gleichzeitig bedienen.

Die Dachkonsole 0 weist weiter zwei Lichtaustrittsflächen 3 auf, die auf die vorderen Sitze gerichtet sind. Die Lichtaustrittsflächen 3 sind gleichzeitig Touch-Bedienelemente. Durch ein Antippen der Touch-Bedienelemente, also der Lichtaustrittsflächen 3, wird die Beleuchtung Ein-und Ausgeschaltet. Bei einem Long-Press, also einem Auflegen und Halten des Fingers auf der Lichtaustrittsfläche 3 wird nach kurzer Verzögerungszeit die Beleuchtungsintensität bei eingeschalteter Beleuchtung langsam gemindert und bei ausgeschalteter Beleuchtung langsam erhöht, bis der Finger von der Lichtaustrittsfläche 3 genommen wird.

Zudem hat die Dachkonsole 0 einen SOS-Taster 4, der unter einer Schutzklappe angeordnet ist, die für ein Auslösen geöffnet werden muss.

Auf der der Frontscheibe abgewandten Seite der Dachkonsole 0 sind Öffnungen 5 für dahinter befindliche Sensorik der Innenraumüberwachung angeordnet. Benachbart befinden sich auf der dem Fahrer zugewandten Seite Öffnungen 6 für ein digitales Mikrofon. Die Öffnungen 5 und 6 sind in matt-schwarzem Kunststoff mit einer geriffelten Oberfläche angeordnet.

Die Dachkonsole 0 hat ein Touch-Bedienelement für einen Pannenruf 7 und ein Touch-Bedienelement für einen Inforuf 8, ein Touch-Bedienelement für die Türkontaktvorwahl 9 und ein Touch-Bedienelement für die Innenraumbeleuchtung 10. Alle Touch-Bedienelemente 7 - 10 sind durch ein Symbol mit Hintergrundbeleuchtung gekennzeichnet, wobei eine Aktivierung einen Farbumschlag des Symbols bewirkt. Zudem ist eine Passenger Airbag Off Anzeige 11 vorhanden. Die Touch-Bedienelemente für Pannenruf 7 Inforuf 8, Türkontaktvorwahl 9, und Innenraumbeleuchtung 10 sowie die Passenger Airbag Off Anzeige 11 befinden sich neben einander auf der der Frontscheibe zugewandten Seite des Dachkonsole 0 und weisen eine durch "In Mould Labelling" hergestellte Hochglanz Oberfläche auf.

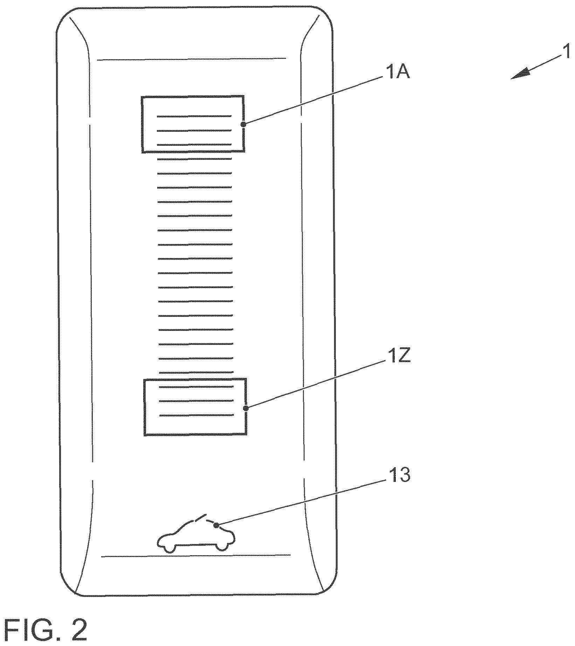

Figur 2 zeigte eine größere Ansicht des Touch-Slide-Bedienelements Dach 1. Es hat Randbereiche 1A, 1Z und ein benachbart angeordnetes Fahrzeugsymbol 13. In Einbauposition ist das Fahrzeugsymbol 13 der Frontscheibe zugewandt. Zur Klarstellung wird angemerkt, dass die in der Figur erkenntlichen Rahmen der Randbereiche 1A, 1Z nur zu Darstellungszwecken ersichtlich sind.

Die Bedienlogik des Touch-Slide-Bedienelements Dach 1 ist wie folgt:
1. Ein einmaliges Tippen auf die Randbereiche 1A, 1Z bewirkt eine automatische vollständige Öffnung oder Schließung der Schiebefunktion. Ein Tippen auf den Randbereich 1Z, also das der Frontscheibe zugewandte Seite des Touch-Slide-Bedienelementes 1, ein vollständiges Schließen der Schiebefunktion und ein Tippen auf den Randbereich 1A ein vollständiges Öffnen der Dachfläche.
2. Ein Tippen und Halten (Long-Press) auf die Randbereiche 1A, 1Z bewirkt ein Öffnungsbeziehungsweise Schließbewegung analog zu Punkt 1, die jedoch mit dem Abheben des Fingers vom Randbereich 1A, 1Z des Touch-Slide-Bedienelements 1 stoppt.
3. Ein Tippen während eines automatischen Öffnungs- oder Schließvorganges der Schiebefunktion bewirkt ein Anhalten an der aktuellen Position.
4. In geschlossener Position des Daches bewirkt ein Tippen auf eine beliebige Stelle des Touch-Slide-Bedienelements Dach 1 ein Ausstellen des Daches. Ein nochmaliges Tippen im ausgestellten Zustand bewirkt ein Schließen der Ausstellfunktion. Ein Tippen während der Bewegung in oder aus der Ausstellfunktion bewirkt ein Stopp in der aktuellen Position.
5. Eine Wischbewegung in Richtung des Randbereiches 1A bewirkt eine vollständige Öffnung der Schiebefunktion. Eine Wischbewegung in Richtung des Randbereiches 1Z ein vollständiges Schließen des Daches, also egal ob Ausstell- oder Schiebefunktion.
6. Eine Wischbewegung mit anschließendem Verweilen des Fingers bewirkt eine Öffnungs- oder Schließbewegung der Schiebefunktion bis der Finger vom Touch-Slide-Bedienelements Dach 1 genommen wird. Auch hier bewirkt dabei eine Wischbewegung in Richtung des Randbereichs 1A eine Öffnung und in Richtung des Randbereichs 1Z eine Schließung.

Die Bedienlogik des Touch-Slide-Bedienelements Sonnenschutz 2 (siehe Fig. 1) ist analog zur oben beschriebenen Bedienlogik des Touch-Slide-Bedienelements Dach 1. Es entfallen jedoch die Bedienfunktionen für die Ausstellfunktion unter Punkt 4. In analoger Weise kann auch die Bedienung der Verdunklung von Funktionsglas erfolgen.

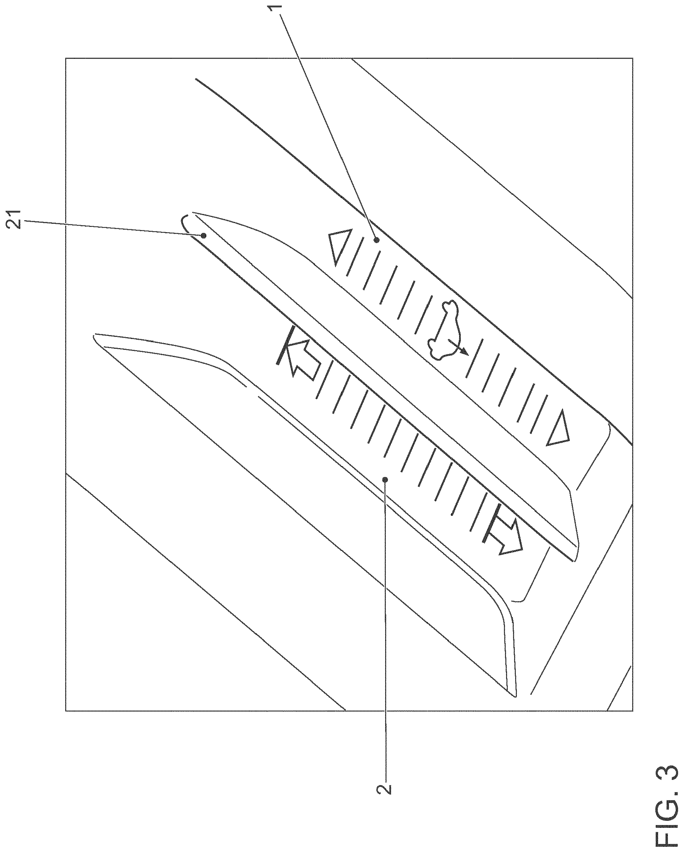

Figur 3 zeigt eine alternative Ausgestaltung der Dachkonsole 0, bei der Touch-Slide-Bedienelemente 1, 2 auf einer Erhöhung angeordnet sind, die durch eine als Spalt ausgebildete Abgrenzung 21 voneinander getrennt sind.

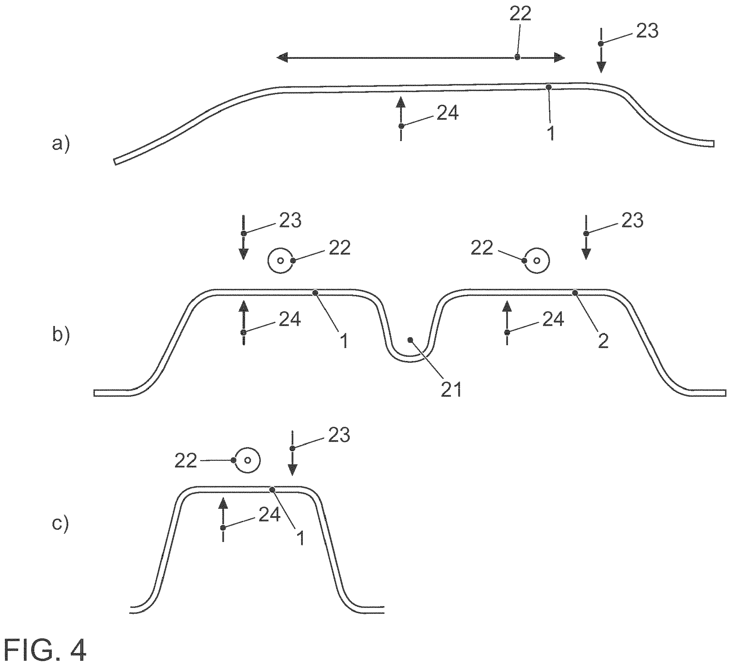

Figur 4 zeigt verschiedene Querschnittsformen der Vertiefung beziehungsweise Erhöhung der Touch-Slide-Bedienelemente 1, 2. Für die Interpretation als Vertiefung gilt eine Bedienungsrichtung (also die Richtung aus der ein Finger auf das Touch-Slide-Bedienelement 1, 2 zur Bedienung geführt wird) 23 und für eine Interpretation als Erhöhung gilt eine Bedienungsrichtung 24.

Figur 4a) zeigt eine Schnittdarstellung durch ein Touch-Slide-Bedienelement 1 in dessen Ausdehnungsrichtung 22. Die Ausdehnungsrichtung 22 gibt dabei die Richtung der eindimensionalen Ausdehnung des Touch-Slide-Bedienelements 1 an, also auch die Richtung in der Wischgesten ausführbar sind.

Figur 4b) zeigt eine Schnittdarstellung zweier Touch-Slide-Bedienelemente 1, 2 in jeweils einer Vertiefung beziehungsweise auf einer Erhöhung quer zu deren Ausdehnungsrichtung 22. Mittig ist die Abgrenzung 21 erkennbar, die bei Interpretation als Vertiefung als Steg ausgeführt ist und bei einer Interpretation als Erhöhung als Spalt. Die Höhe des Steges beziehungsweise Tiefe des Spaltes beträgt dabei circa die halbe Tiefe der Vertiefung beziehungsweise Höhe der Erhöhung.

Figur 4c) zeigt eine Schnittdarstellung analog zu Figur 4b), wobei hier ein einzelnes Touch-Slide-Bedienelement 1 in einer Vertiefung/auf einer Erhöhung angeordnet ist.

Gut erkennbar in den Schnittdarstellungen der Figur 4 ist die Trapezform des Querschnittes der Vertiefung/Erhöhung, also das die Breite und die Läng der Vertiefung/ Erhöhung mit zunehmender Tiefe/ Höhe abnehmen.

### Bezugszeichenliste

- 0: Dachkonsole
- 1: Touch-Slide-Bedienelement Dach
- 2: Touch-Slide-Bedienelement Sonnenschutz
- 21: Abgrenzung
- 22: Ausdehnungsrichtung Touch-Slide-Bedienelement
- 23: Bedienungsrichtung Erhöhung
- 24: Bedienungsrichtung Vertiefung
- 3: Lichtaustrittsfläche
- 4: SOS-Taster
- 5: Öffnungen Sensorik Innenraumüberwachung
- 51: Sensorik und Steuerelektronik der Innenraumüberwachung
- 6: Öffnungen Mikrofon
- 7: Touch-Bedienelement Pannenruf
- 8: Touch-Bedienelement Inforuf
- 9: Touch-Bedienelement Türkontaktvorwahl
- 10: Touch-Bedienelement Innenraumbeleuchtung
- 11: Anzeige Passenger Airbag Off
- 13: Fahrzeugsymbol
- 1A: Randbereich
- 1Z: Randbereich

## Patentansprüche

1. Dachkonsole (0) für ein Fahrzeug aufweisend mindestens ein Touch-Slide-Bedienelement (1, 2) zur Bedienung von Fahrzeugfunktionen, wobei die Oberfläche mindestens eines der Touch-Slide-Bedienelemente (1, 2) gegenüber der Oberfläche der Umgebung des Touch-Slide-Bedienelementes (1, 2) in einer Vertiefung oder auf einer Erhöhung angeordnet ist, **dadurch gekennzeichnet, dass** die Vertiefung mit zunehmender Tiefe schmaler wird oder die Erhöhung sich mit zunehmender Höhe verjüngt.

2. Dachkonsole (0) nach Anspruch 1, **dadurch gekennzeichnet, dass** zwei Touch-Slide-Bedienelemente (1, 2) unmittelbar nebeneinander angeordnet und durch eine Abgrenzung (21) getrennt sind.

3. Dachkonsole (0) nach Anspruch 2, **dadurch gekennzeichnet, dass** die Abgrenzung (22) eine Erhöhung oder Vertiefung ist, die die zwischen dem Höhenniveau von Touch-Slide-Bedienelement (1, 2) und Oberfläche der Umgebung liegt.

4. Dachkonsole (0) nach einem der vorangehenden Ansprüche, **dadurch gekennzeichnet, dass** in Einbauposition mindestens ein Touch-Slide-Bedienelement (1, 2) in Fahrtrichtung des Fahrzeugs ausgerichtet ist.

5. Dachkonsole (0) nach einem der vorangehenden Ansprüche, **dadurch gekennzeichnet, dass** in Einbauposition zwei, in Fahrtrichtung des Fahrzeugs ausgerichtete Touch-Slide-Bedienelemente (1, 2) nebeneinander jeweils in einer Vertiefung oder auf einer Erhöhung angeordnet sind, wobei beide Vertiefungen/Erhöhungen durch eine Abgrenzung getrennt sind, wobei die Höhe der Abgrenzung zwischen dem Höhenniveau der Umgebung der Touch-Slide-Bedienelemente (1, 2) und dem Höhenniveau der Touch-Slide-Bedienelemente (1, 2) liegt.

6. Dachkonsole (0), nach einem der vorangehenden Ansprüche, **dadurch gekennzeichnet, dass** das die bedienbaren Fahrzeugfunktionen ein Schiebe- und/oder Ausstelldach, ein öffenbarer Sonnenschutz eines Schiebe-/Ausstelldaches, verdunkelbares Funktionsglas, ein Cabrio Verdeck, eine motorische Heckklappe, ein Fensterheber oder eine Innenraumbeleuchtung sind.

7. Dachkonsole (0) nach einem der vorangehenden Ansprüche, **dadurch gekennzeichnet, dass** die Dachkonsole (0) ein oder mehrere der folgenden Bauteile aufweist: dimmbare Beleuchtung, digitales Mikrofon, Passenger Airbag Off Anzeige (11), Sensorik zur Überwachung des Fahrzeuginnenraumes (51), SOS-Taster (4).

8. Dachkonsole (0), nach einem der vorangehenden Ansprüche, **dadurch gekennzeichnet, dass** das Touch-Slide-Bedienelement (1, 2) einen kapazitiven Sensor aufweist.

9. Dachkonsole (0), nach einem der vorangehenden Ansprüche, **dadurch gekennzeichnet, dass** ein Touch-Slide-Bedienelement (1, 2) mehrere Fahrzeugfunktionen gleichzeitig bedient.

## Claims

1. Roof console (0) for a vehicle, having at least one touch-slide operator control element (1, 2) for operating vehicle functions, wherein the surface of at least one of the touch-slide operator control elements (1, 2) is arranged in a recess or on a raised portion in relation to the surface of the area surrounding the touch-slide operator control element (1, 2), **characterized in that** the recess becomes narrower as the depth increases or the raised portion tapers as the height increases.

2. Roof console (0) according to Claim 1, **characterized in that** two touch-slide operator control elements (1, 2) are arranged directly next to one another and are separated by a boundary (21).

3. Roof console (0) according to Claim 2, **characterized in that** the boundary (22) is a raised portion or recess which is situated between the height level of the touch-slide operator control element (1, 2) and the surface of the surrounding area.

4. Roof console (0) according to one of the preceding claims, **characterized in that** in the installation position at least one touch-slide operator control element (1, 2) is oriented in the direction of travel of the vehicle.

5. Roof console (0) according to one of the preceding claims, **characterized in that** in the installation position two touch-slide operator control elements (1, 2) oriented in the direction of travel of the vehicle are arranged next to one another in each case in a recess or on a raised portion, wherein the two recesses/raised portions are separated by a boundary, wherein the height of the boundary lies between the height level of the area surrounding the touch-slide operator control elements (1, 2) and the height level of the touch-slide operator control elements (1, 2).

6. Roof console (0) according to one of the preceding claims, **characterized in that** the operable vehicle functions are a sliding and/or tilting roof, an openable sunshade of a sliding/tilting roof, functional glass that can be darkened, a convertible roof, a motorized rear hatch, a window winder or an interior lighting system.

7. Roof console (0) according to one of the preceding claims, **characterized in that** the roof console (0) has one or more of the following components: dimmable lighting system, digital microphone, passenger airbag off display (11), sensor system for monitoring the vehicle interior (51), SOS button (4).

8. Roof console (0) according to one of the preceding claims, **characterized in that** the touch-slide operator control element (1, 2) has a capacitive sensor.

9. Roof console (0) according to one of the preceding claims, **characterized in that** a touch-slide operator control element (1, 2) operates several vehicle functions simultaneously.

## Revendications

1. Console de toit (0) pour un véhicule, présentant au moins un élément d'utilisation à curseur tactile (1, 2) pour utiliser des fonctions de véhicule, dans laquelle la surface d'au moins l'un des éléments d'utilisation à curseur tactile (1, 2) est disposée dans un creux ou sur un relief par rapport à la surface de l'environnement de l'élément d'utilisation à curseur tactile (1, 2),
**caractérisée en ce que** le creux s'amincit avec une profondeur croissante ou le relief s'amincit avec une hauteur croissante.

2. Console de toit (0) selon la revendication 1, **caractérisée en ce que** deux éléments d'utilisation à curseur tactile (1, 2) sont disposés directement l'un à côté de l'autre et sont séparés par une délimitation (21) .

3. Console de toit (0) selon la revendication 2, **caractérisée en ce que** la délimitation (22) est un relief ou un creux qui se trouve entre le niveau de l'élément d'utilisation à curseur tactile (1, 2) et la surface de l'environnement.

4. Console de toit (0) selon l'une quelconque des revendications précédentes, **caractérisée en ce que** dans la position d'installation, au moins un élément d'utilisation à curseur tactile (1, 2) est orienté dans le sens de la marche du véhicule.

5. Console de toit (0) selon l'une quelconque des revendications précédentes, **caractérisée en ce que** dans la position d'installation, deux éléments d'utilisation à curseur tactile (1, 2) orientés dans le sens de la marche du véhicule sont disposés côte à côte respectivement dans un creux ou sur un relief, dans laquelle les deux creux/reliefs sont séparés par une délimitation, la hauteur de la délimitation se trouvant entre le niveau de l'environnement des éléments d'utilisation à curseur tactile (1, 2) et le niveau des éléments d'utilisation à curseur tactile (1, 2).

6. Console de toit (0), selon l'une quelconque des revendications précédentes, **caractérisée en ce que** les fonctions de véhicule utilisables sont un toit ouvrant coulissant et/ou relevé, un pare-soleil pouvant être ouvert d'un toit ouvrant coulissant/relevé, une vitre fonctionnelle pouvant être obscurcie, une capote de cabriolet, un hayon motorisé, un lève-vitre ou un éclairage d'habitacle.

7. Console de toit (0) selon l'une quelconque des revendications précédentes, **caractérisée en ce que** la console de toit (0) présente un ou plusieurs des composants suivants : un éclairage variable, un microphone numérique, un affichage airbag passager désactivé (11), des capteurs pour surveiller l'habitacle de véhicule (51), une touche SOS (4).

8. Console de toit (0), selon l'une quelconque des revendications précédentes, **caractérisée en ce que** l'élément d'utilisation à curseur tactile (1, 2) présente un capteur capacitif.

9. Console de toit (0), selon l'une quelconque des revendications précédentes, **caractérisée en ce qu'**un seul élément d'utilisation à curseur tactile (1, 2) permet d'utiliser plusieurs fonctions de véhicule en même temps.
